# EUROPEAN PATENT APPLICATION

(11) **EP 4 227 000 A1**
(43) Date of publication of application: **16.08.2023**
(21) Application number: 21875886.0
(22) Date of filing: 01.10.2021
(51) Int. Cl.: B01J 19/12, B01J 19/18, H05B 6/70

(54) **MICROWAVE PROCESSING DEVICE, AND MICROWAVE PROCESSING METHOD**

(30) Priority: 01.10.2020 JP 2020167352
(71) Applicant: Microwave Chemical Co., Ltd., Osaka-shi, Osaka 559-0025 (JP)
(72) Inventor: TSUKAHARA, Yasunori, Osaka-shi, Osaka 559-0025 (JP); WATANABE, Hisao, Osaka-shi, Osaka 559-0025 (JP); ISHIZUKA, Akinori, Osaka-shi, Osaka 559-0025 (JP); KINJO, Ryuhei, Osaka-shi, Osaka 559-0025 (JP)
(74) Representative: Betten & Resch
(86) International application number: PCT/JP2021/036465
(87) International publication number: WO 2022/071590

(57) **Abstract**

The present invention provides a microwave treatment apparatus capable of suppressing the occurrence of sparking in a vessel. A microwave treatment apparatus 1 includes: a vessel 3 having a pillar-shaped hollow portion 3a configured to contain a liquid-phase content 31 to be subjected to batch processing using microwaves, and an upper inner face 3b whose height decreases along a direction from a central axis of the hollow portion 3a to the periphery when the vessel 3 is located such that a direction along the central axis is along a vertical direction; a microwave generator 5 that generates microwaves; and a waveguide 7 having a portion 7a protruding from the upper inner face 3b into the hollow portion 3a, and configured to introduce microwaves generated by a microwave generator 5 into the hollow portion 3a.

## Description

### Technical Field

The present invention relates to a microwave treatment apparatus and a microwave treatment method for irradiating a liquid-phase object with microwaves.

### Background Art

In the case of performing batch processing in a reactor for liquid-phase reactions, the raw materials and necessary solvents are fed into the reactor, and the temperature and pressure are set. The reaction is then facilitated through microwave irradiation to obtain a target product. The temperature is then lowered, and if necessary, the pressure is returned to ambient pressure, and the target product, byproducts, and solvents are collected. The treatment is repeated as many times as necessary.

### Summary of the Invention

### Technical Problem

Liquid-phase reactions have an issue regarding sparking caused by gas generated during the reactions. When droplets generated by gas condensation on the inner wall of the reactor fall from the inner wall, a potential difference is generated between the droplets and the inner wall, resulting in sparking. In particular, droplets tend to condense on the upper inner face of the reactor, which is one of the causes of sparking. Sparks can serve as an ignition point and cause combustion of the gas in the reactor, which in turn may lead to an explosion. Thus, it is required to suppress sparking from the viewpoint of safety.

Sparking caused by such gases is an issue not only for reactors for chemical reactions but also for vessels in general that irradiate a liquid-phase content with microwaves.

The present invention was made in view of these problems, and it is an object thereof to suppress the occurrence of sparking in a microwave treatment apparatus and a microwave treatment method for irradiating a liquid-phase object with microwaves.

### Solution to the Problem

In order to achieve the above-mentioned object, an aspect of the present invention is directed to a microwave treatment apparatus including: a vessel having a pillar-shaped hollow portion configured to contain a liquid-phase content, and an upper inner face that includes at least partial area whose height decreases along a direction from a central axis of the hollow portion to the periphery when the vessel is located such that a direction along the central axis is along a vertical direction; and a waveguide having a portion protruding from the upper inner face into the hollow portion, and configured to introduce microwaves into the hollow portion.

An aspect of the present invention may be directed to the microwave treatment apparatus further including a microwave generator that generates microwaves, wherein microwaves generated by the microwave generator are introduced into the hollow portion via the waveguide.

An aspect of the present invention may be directed to the microwave treatment apparatus further including: a stirring shaft that penetrates the upper inner face of the vessel, and is coaxial with the central axis of the hollow portion; and a stirring blade that is connected to the stirring shaft.

An aspect of the present invention may be directed to the microwave treatment apparatus in which the waveguide is provided such that a central axis of the waveguide is at an angle to the central axis of the hollow portion.

An aspect of the present invention may be directed to the microwave treatment apparatus in which a plane including an opening at an end of the waveguide is perpendicular to the central axis of the hollow portion.

An aspect of the present invention may be directed to the microwave treatment apparatus in which a surface of the upper inner face of the hollow portion has good wettability to the content.

An aspect of the present invention may be directed to the microwave treatment apparatus in which the vessel includes an outer-pipe portion protruding outward from the vessel and having one end that is connected to the hollow portion at the upper inner face, and the waveguide includes an inner-pipe waveguide located inside the outer-pipe portion such that one end thereof protrudes from the upper inner face into the hollow portion.

An aspect of the present invention may be directed to the microwave treatment apparatus in which the waveguide penetrates an opening formed through the vessel, and the waveguide is welded to the vessel at the opening.

An aspect of the present invention may be directed to the microwave treatment apparatus in which the waveguide includes a waveguide outside the vessel and a waveguide inside the vessel, the waveguides facing each other at an opening formed through the vessel, and the waveguide inside the vessel is detachably attached to the vessel.

An aspect of the present invention is directed to a microwave treatment method including: a step of allowing a liquid-phase content to flow into a pillar-shaped hollow portion included in a vessel and configured to contain the content when the vessel is located such that a direction along a central axis of the hollow portion is along a vertical direction; and a step of irradiating the content with microwaves emitted via a waveguide having a portion protruding from an upper inner face of the vessel into the hollow portion, wherein the upper inner face includes at least partial area whose height decreases along a direction from the central axis to the periphery.

### Advantageous Features of the Invention

In accordance with an aspect of the present invention, it is possible to suppress the occurrence of sparking in a vessel.

### Brief Description of the Drawings

FIG. 1 is a front view showing the configuration of a microwave treatment apparatus according to an embodiment of the present invention.
FIG. 2 is a plan view showing the microwave treatment apparatus according to the embodiment.
FIG. 3 is a vertical cross-sectional view showing the microwave treatment apparatus according to the embodiment.
FIG. 4 is a vertical cross-sectional view showing another example of the microwave treatment apparatus according to the embodiment.
FIG. 5 is a cross-sectional view showing a connection state with a waveguide in the embodiment.
FIG. 6 is a cross-sectional view showing another example of a connection state between the vessel and the waveguide in the embodiment.
FIG. 7 is a cross-sectional view showing another example of a connection state between the vessel and the waveguide in the embodiment.
FIG. 8A is a diagram showing a simulation result of Comparative Example 1.
FIG. 8B is a diagram showing a simulation result of Comparative Example 2.
FIG. 8C is a diagram showing a simulation result of Example 1.
FIG. 8D is a diagram showing a simulation result of Example 2.
FIG. 8E is a diagram showing a simulation result of Example 3.
FIG. 8F is a diagram showing a simulation result of Example 4.

### Description of the Preferred Embodiment

Hereinafter, an embodiment of the microwave treatment apparatus and the microwave treatment method according to the present invention will be described. In the embodiment below, the constituent elements denoted by the same reference numerals are the same or similar to each other, and thus a description thereof may not be repeated. A vessel provided in the microwave treatment apparatus according to this embodiment has a hollow portion whose upper inner face has a dome-like shape, for example. A liquid-phase content is irradiated with microwaves introduced into the vessel via a waveguide protruding from the upper inner face into the hollow portion.

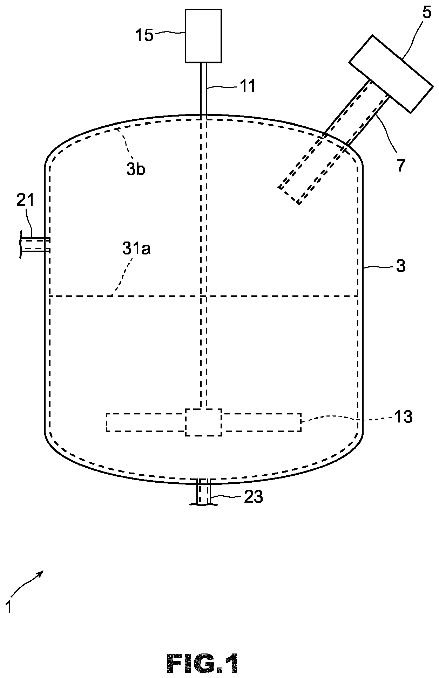

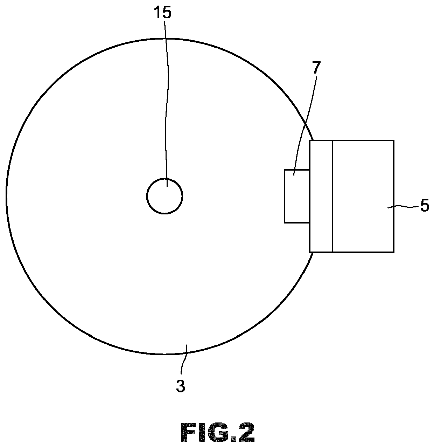

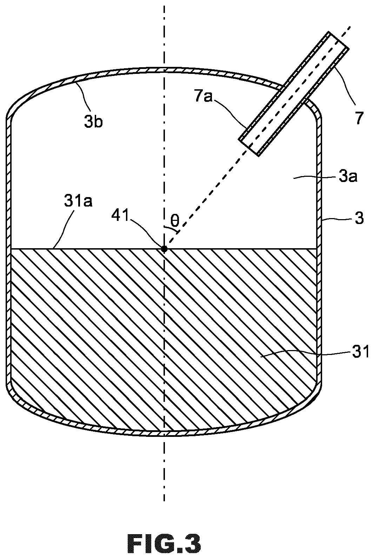

FIG. 1 is a front view showing the configuration of a microwave treatment apparatus 1 according to this embodiment. FIG. 2 is a plan view of the microwave treatment apparatus 1. FIG. 3 is a vertical cross-sectional view of the microwave treatment apparatus 1. In FIG. 3, some constituent elements such as a microwave generator 5 and a stirring shaft 11 are not shown for the sake of ease of description.

The microwave treatment apparatus 1 includes a vessel 3 having a hollow portion 3a having a round pillar shape and a waveguide 7 configured to introduce microwaves into the hollow portion 3a, and may further include a microwave generator 5, a stirring shaft 11, a stirring blade 13 attached to the stirring shaft 11, and a drive unit 15 configured to rotate the stirring shaft 11, as necessary. In the following description, the upper direction and the lower direction of the vessel 3 that is located such that the central axis of the hollow portion 3a having a round pillar shape and included in the vessel 3 is along the vertical direction are respectively referred to as an "upper direction" and a "lower direction". The vertical direction may be the exact vertical direction, or may include directions that deviate from the exact vertical direction by a minute angle that is about the installation error of the vessel 3.

The vessel 3 includes the hollow portion 3a having a round pillar shape and configured to contain a liquid-phase content 31 to be subjected to batch processing using microwaves. The hollow portion 3a may be shaped to include a portion having a round pillar shape, and an outwardly bulging portion such as a portion with a dome-like shape or a hemispherical shape at one or two ends in the central axis direction of the portion having a round pillar shape, for example. The hollow portion 3a may be in the form of a rotating member that rotates about the central axis. The hollow portion 3a is typically a space in which microwaves are confined. Accordingly, the vessel 3 is preferably made of a material that does not transmit microwaves. The material that does not transmit microwaves may be a microwave reflective material. The microwave reflective material may be a metal, for example. Examples of the metal include, but are not particularly limited to, a stainless steel, a carbon steel, nickel, a nickel alloy, copper, and a copper alloy.

The liquid-phase content 31 may be a liquid, a slurry, or other liquid-phase substances, for example. Specifically, the liquid-phase content 31 may be raw materials of the target product and necessary solvent. Examples of the microwave batch processing performed on the content 31 include, but are not particularly limited to, heat treatment, chemical reaction treatment, and sterilization treatment. Examples of the chemical reaction treatment include, but are not particularly limited to, treatment that produces biodiesel fuel, sugar fatty acid esters, or the like through an esterification reaction or an ester exchange reaction, treatment that produces metal nanoparticles through a reduction reaction, and other chemical reaction treatment. If chemical reaction treatment is performed on the content 31, the vessel 3 may be a reactor. The batch processing on the content 31 may be performed at ambient pressure, under reduced pressure, or under pressure, for example.

The vessel 3 may include an inlet pipe 21 configured to introduce the content 31 into the hollow portion 3a and an outlet pipe 23 configured to discharge the content 31 from the hollow portion 3a. The inlet pipe 21 and the outlet pipe 23 may be provided with a valve. The inflow and outflow of the content 31 may be stopped when batch processing is performed in the vessel 3. It is preferable that the inlet pipe 21 and the outlet pipe 23 are also made of a material that does not transmit microwaves. The inner diameter, the attachment position, and the like of the inlet pipe 21 and the outlet pipe 23 may be determined so as to prevent leakage of microwaves from the inlet pipe 21 and the outlet pipe 23, and components such as a perforated metal board or a metal mesh for preventing leakage of microwaves may be arranged at the inlet port of the inlet pipe 21 or the outlet port of the outlet pipe 23. Although FIG. 1 shows a case in which the inlet pipe 21 is located at a position higher than a liquid surface 31a of the content 31 and the outlet pipe 23 is located at the lowest position of the hollow portion 3a, the inlet pipe 21 and the outlet pipe 23 may be located at positions other than those shown in FIG. 1. The vessel 3 may have an exhaust port for venting steam on an upper inner face 3b or the like, for example.

The vessel 3 includes the upper inner face 3b whose height decreases from the center to the periphery when the vessel is located such that a direction along the central axis of the hollow portion 3a is along the vertical direction. The upper inner face 3b may have a dome-like shape, a hemispherical shape, a conical shape, or any other shape whose height decreases from the center to the periphery, for example. In this embodiment, a case will be mainly described in which the upper inner face 3b has a dome-like shape as shown in FIGS. 1 and 3. If the upper inner face 3b has a height that decreases along a direction from the central axis to the periphery, droplets generated on the upper inner face 3b are facilitated to move along the inner wall to the side face without falling from the upper inner face 3b, and thus sparking associated with falling droplets is suppressed. Although this embodiment shows a case in which the height of the entire upper inner face 3b decreases from the center to the periphery, sparking associated with falling droplets can be suppressed to some extent by setting at least partial area of the upper inner face 3b to have a height that decreases along a direction from the central axis to the periphery.

The waveguide 7 introduces microwaves generated by the microwave generator 5 into the hollow portion 3a. The content 31 is irradiated with the microwaves introduced into the hollow portion 3a in this manner. The microwave irradiation in the hollow portion 3a can be performed in multimode. The waveguide 7 includes a portion 7a protruding from the upper inner face 3b. The protruding portion 7a is a portion protruding from the upper inner face 3b into the hollow portion 3a. The inventors of the present invention have found that the presence of the protruding portion 7a can suppress the concentration of the microwave electric field on the upper inner face 3b of the hollow portion 3a. As a result, the potential difference between a droplet falling from the upper inner face 3b and the upper inner face 3b decreases, and thus the occurrence of sparking is suppressed even when a droplet falls.

The waveguide 7 may specifically be a hollow waveguide. The waveguide 7 is typically a rectangular waveguide with a rectangular cross section, but may be a circular waveguide with a circular cross section. In this embodiment, a case will be mainly described in which the waveguide 7 is a rectangular waveguide.

The surface of the upper inner face 3b of the hollow portion 3a may have good wettability to the content 31. In this case, for example, the upper inner face 3b of the vessel 3 may be made of a material that has good wettability to the content 31, or the upper inner face 3b of the hollow portion 3a may be coated with a material that has good wettability to the content 31. The material that has good wettability to the content 31 may be titanium dioxide having hydrophilic properties, for example, if the content 31 contains water and the water condenses on the upper inner face 3b. If the content 31 contains water and the water condenses on the upper inner face 3b, a ceramic coating may be applied to the upper inner face 3b of the vessel 3. For example, the upper inner face 3b of the vessel 3 may be subjected to surface treatment for improving the wettability to the content 31. The surface treatment may be treatment to reduce surface irregularities or to reduce surface roughness, for example. Examples of such surface treatment may include buffing or other polishing process. The surface having good wettability to the content 31 may be a surface with a contact angle to the content 31 of 90° or less, 80° or less, 70° or less, 60° or less, or 50° or less, for example. The higher the affinity between the content 31 and the surface of the upper inner face 3b, the lower the possibility of liquid of the content 31 having condensed on the upper inner face 3b falling as droplets. Therefore, a smaller contact angle to the content 31 at the surface of the upper inner face 3b is preferable.

The microwave generator 5 generates microwaves. The microwave generator 5 may generate microwaves using a magnetron, a klystron, a gyrotron, or the like, or using a semiconductor device, for example. The frequency of microwaves may be 915 MHz, 2.45 GHz, 5.8 GHz, or 24 GHz, or other frequencies ranging from 300 MHz to 300 GHz, for example. The intensity of microwaves may be controlled as appropriate by a controller (not shown), and the control may be feedback control using sensing results such as the temperature of the content 31, for example.

The central axis of the waveguide 7 is preferably at an angle θ to the central axis of the hollow portion 3a as shown in FIG. 3, for example. In FIG. 3, the central axis of the hollow portion 3a is indicated by a dash-dotted line. If the central axis of the waveguide 7 is at an angle to the central axis of the hollow portion 3a, the angle between the central axis of the waveguide 7 and the central axis of the hollow portion 3a may be in the range of 20° to 70°, 30° to 60°, or 40° to 50°, for example. This angle may be 45°. If the angle θ is provided, it is possible to suppress a decrease in the irradiation efficiency caused by reflection of emitted microwaves back to the waveguide 7.

If the central axis of the waveguide 7 is at an angle to the central axis of the hollow portion 3a, the waveguide 7 may be located such that the central axis of the hollow portion 3a intersects a straight line including the central axis of the waveguide 7. In FIG. 3, the straight line including the central axis of the waveguide 7 is indicated by a broken line. If the central axis of the hollow portion 3a intersects the straight line including the central axis of the waveguide 7, their intersection 41 may be on the liquid surface 31a of the content 31 as shown in FIG. 3. In this case, the center of the liquid surface is irradiated with microwaves, and efficient microwave irradiation can be realized. If the waveguide 7 is curved in part from the microwave generator 5 to the opening at the end of the waveguide in the hollow portion 3a, the straight line including the central axis of the waveguide 7 may be a straight line including the central axis on that end side of the waveguide 7.

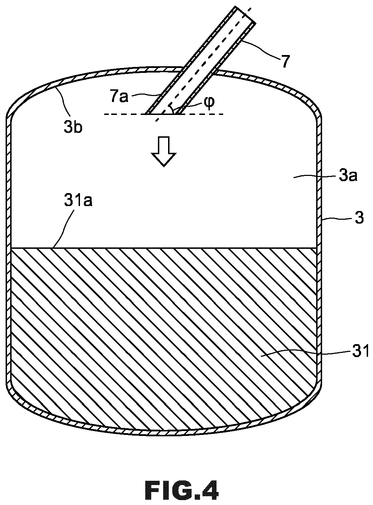

Furthermore, a plane including the opening at the end on the hollow portion 3a side of the waveguide 7 may be perpendicular to the central axis of the hollow portion 3a as shown in FIG. 4. That is to say, the plane including the opening at the end of the waveguide 7 may be parallel to the liquid surface 31a of the content 31. In FIG. 4, the plane including the opening at the end of the waveguide 7 and the central axis of the waveguide 7 are indicated by broken lines. It is possible to change the orientation of microwaves emitted from the end of the waveguide 7, by setting the angle between the plane including the opening at the end of the waveguide 7 and the central axis of the waveguide 7 to an angle other than a right angle in this manner. In FIG. 4, the angle φ between the central axis of the waveguide 7 and the plane including the opening at the end of the waveguide 7 may be in the range of 20° to 90°, for example. Typically, microwaves emitted from the end of the waveguide 7 are emitted in a direction that is perpendicular to the plane including the opening at the end of the waveguide 7. Therefore, in the case shown in FIG. 4, microwaves emitted from the waveguide 7 will generally travel in a direction that is perpendicular to the liquid surface 31a of the content 31 as indicated by the arrow in the drawing, and thus the electric field concentration on the upper inner face 3b can be suppressed.

A window that transmits microwaves may be provided at any point of the waveguide 7 in order to prevent vapor, particles, and the like from migrating from the hollow portion 3a toward the microwave generator 5. The window may be made of a material that transmits microwaves such as quartz, glass, fluororesin (e.g., polytetrafluoroethylene), or ceramic. The window may be an airtight window or a non-airtight window, for example.

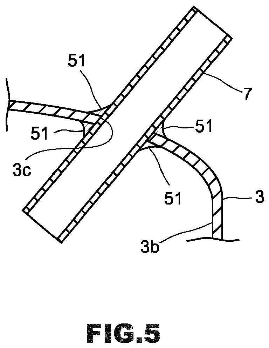

Next, the connection structure between the waveguide 7 and the vessel 3 will be described. As shown in FIG. 5, the waveguide 7 may penetrate an opening 3c formed through the vessel 3, and the waveguide 7 may be welded to the vessel 3 at the opening 3c. Although the cross-sectional view in FIG. 5 shows a case in which welding 51 is performed on both the outer circumferential face side and the inner circumferential face side (i.e., the upper inner face 3b of the hollow portion 3a) of the vessel 3, the welding may be performed only on one of these sides. The welding 51 is preferably performed around the outer circumferential face of the waveguide 7. This is to prevent leakage of microwaves from the opening 3c.

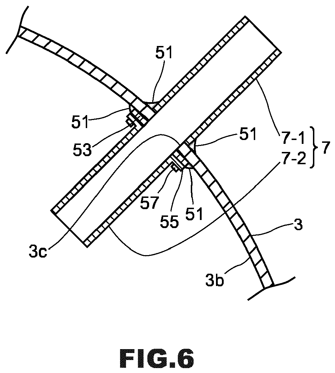

Furthermore, as shown in FIG. 6, the waveguide 7 may include a waveguide 7-1 outside the vessel 3 and a waveguide 7-2 inside the vessel 3, the waveguides facing each other at the opening 3c formed through the vessel 3. The waveguide 7-2 inside the vessel 3 may be detachably attached to the vessel 3. In this case, the waveguide 7-2 may be detachably attached to a bolt hole formed in the upper inner face 3b or to a flange connected to the upper inner face 3b by means of a bolt, for example. In the cross-sectional view in FIG. 6, the outer waveguide 7-1 is welded to the outer circumferential face side of the vessel 3. A flange 53 having a hole with the same inner diameter as that of the waveguides 7-1 and 7-2 is fixed to the upper inner face 3b of the vessel 3 by means of the welding 51. A flange portion 55 of the waveguide 7-2 is fixed to the flange 53 by means of a bolt 57. Therefore, it is possible to detach the inner waveguide 7-2 and replace the inner waveguide 7-2 by detaching the bolt 57. It is assumed that all the outer waveguide 7-1, the opening 3c, the hole of the flange 53, and the inner waveguide 7-2 are coaxial, and a microwave guide path is defined by their inner circumferential faces. Also, it is assumed that the inner diameter of the opening 3c is the same as that of the waveguides 7-1 and 7-2 and the flange 53. Since the inner waveguide 7-2 is detachable in this manner, when increasing or reducing the amount of the content 31 in the vessel 3, it is possible to use an inner waveguide 7-2 with a corresponding length, for example. For example, if the amount of the content 31 is small and the height of the liquid surface 31a decreases, it is possible to attach a longer inner waveguide 7-2 such that a point closer to the content 31 can be irradiated with microwaves. On the other hand, if the height of the liquid surface 31a increases, it is possible to attach a shorter inner waveguide 7-2 such that the end of the waveguide 7-2 is prevented from contacting the liquid surface 31a. If the end of the waveguide 7-2 is at an appropriate distance from the liquid surface 31a, the possibility of the content 31 entering the inside of the waveguide 7-2 can be reduced, for example. Since the inner waveguide 7-2 is detachable, it is possible to change the shape of the opening at the end of the waveguide 7-2 according to the height of the content 31 and the like. For example, if the central axis of the waveguide 7-2 is at an angle to the central axis of the hollow portion 3a, it is possible to attach a waveguide 7-2 whose plane including the opening at the end thereof is perpendicular to the longitudinal direction of the waveguide 7-2 in the case in which the liquid surface 31a is high, and to attach a waveguide 7-2 whose plane including the opening at the end thereof is perpendicular to the central axis of the hollow portion 3a in the case in which the liquid surface 31a is low.

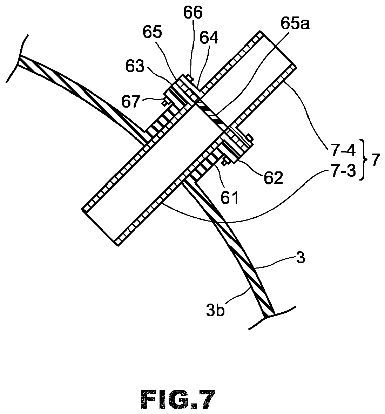

Furthermore, as shown in FIG. 7, the waveguide 7 may include an inner-pipe waveguide 7-3 inside an outer-pipe portion 61 formed on the vessel 3. The vessel 3 shown in FIG. 7 includes the outer-pipe portion 61 protruding outward from the vessel 3. One end of the outer-pipe portion 61, on the vessel 3 side, is connected with the hollow portion 3a at the upper inner face 3b. The other end of the outer-pipe portion 61, on the side opposite to the hollow portion 3a, includes a flange portion 62. The waveguide 7 includes the inner-pipe waveguide 7-3 located inside the outer-pipe portion 61 such that one end thereof protrudes from the upper inner face 3b into the hollow portion 3a, and a waveguide 7-4 connected to the inner-pipe waveguide 7-3 via an airtight window 65. The inner diameter of the outer-pipe portion 61 is preferably substantially the same as the outer diameter of the inner-pipe waveguide 7-3. One end of the inner-pipe waveguide 7-3, on the side opposite to the hollow portion 3a, includes a flange portion 63. It is possible to attach the waveguide 7 to the vessel 3 by tightening the flange portion 62 of the outer-pipe portion 61, the flange portion 63 of the inner-pipe waveguide 7-3, and a flange portion 64 of the waveguide 7-4, via the airtight window 65 having a transmitting portion 65a made of a material that transmits microwaves, using a bolt 66 and a nut 67. Since the inner-pipe waveguide 7-3 is detachable from the vessel 3 in this case as well, it is possible to use an inner-pipe waveguide 7-3 according to desired microwave irradiation. Although FIG. 7 shows a case in which the inner-pipe waveguide 7-3 and the waveguide 7-4 are connected to each other via the airtight window 65 as an example, the airtight window 65 does not have to be provided or may be provided at another position. The inner-pipe waveguide 7-3 may be directly connected to the microwave generator 5. The outer-pipe portion 61 and the inner-pipe waveguide 7-3 may be fixed to each other using a method other than that using a flange, such as welding, for example.

The stirring shaft 11 penetrates the upper inner face 3b of the vessel 3 and is coaxial with the central axis of the hollow portion 3a. To prevent leakage of microwaves, a microwave leakage prevention mechanism such as a choke structure may be provided in the through-hole formed through the upper face of the vessel 3 for the stirring shaft 11. The stirring blade 13 is connected to the lower end of the stirring shaft 11. As long as the content 31 can be stirred as appropriate inside the vessel 3, there is no limitation on the shape of the stirring blade 13. The drive unit 15 rotates the stirring shaft 11. The drive unit 15 may be a motor or the like provided outside the vessel 3, for example. When the drive unit 15 rotates the stirring shaft 11, the stirring blade 13 fixed to the stirring shaft 11 rotates and stirs the content 31. Although FIG. 1 shows a case in which the microwave treatment apparatus 1 includes the stirring shaft 11, the stirring blade 13, and the drive unit 15 (hereinafter, these components may be referred to as a "stirring unit"), the microwave treatment apparatus 1 does not have to include the stirring unit in the case in which the content 31 does not need to be stirred.

In the description above, the hollow portion 3a included in the vessel 3 has been described as having a round pillar shape, but the spirit of the present invention is equally applicable to the case where a cross-section of the hollow portion 3a has an elliptical or other circular shapes that are not a regular circle. The hollow portion 3a with a circular cross-section that is not a regular circle is referred to as a "round pillar-like shape" in this specification. If the central axis of such a round pillar-like shape cannot be strictly defined, any of the central axes of the hollow portion 3a obtained by approximating each cross-section with the round pillar-like shape with an circular shape whose central point can be defined can be used to interpret the description herein. The hollow portion 3a may have a square pillar shape or a square pillar-like shape with a quadrangular cross-section that is not a regular square. If the central axis of such a square pillar-like shape cannot be strictly defined, any of the central axes of the hollow portion 3a obtained by approximating each cross-section with the square pillar-like shape with a quadrangular shape whose central point can be defined can be used to interpret the description herein. More generally, the hollow portion 3a may be described as having a pillar shape.

In this embodiment, the case was described in which the microwave treatment apparatus 1 includes the microwave generator 5, but there is no limitation to this. The microwave treatment apparatus 1 does not have to include the microwave generator 5.

The present invention is not limited to the embodiment set forth herein. Various modifications are possible within the scope of the invention.

Next, the batch processing in the microwave treatment apparatus 1 according to this embodiment will be described. First, in a state in which the valve of the outlet pipe 23 is closed, the valve of the inlet pipe 21 is opened to allow the content 31 to flow into the hollow portion 3a of the vessel 3. When a predetermined amount of the content 31 has flowed in, the valve of the inlet pipe 21 is closed. Then, the microwave generator 5 is caused to generate microwaves. The microwaves generated by the microwave generator 5 are introduced into the hollow portion 3a via the waveguide 7, and the content 31 is irradiated with the microwaves. The content 31 is heated through the microwave irradiation and thus predetermined treatment is performed. Even when part of the content 31 evaporates and condenses on the upper inner face 3b of the hollow portion 3a during the treatment, most of the condensed liquid flows along the upper inner face 3b toward the hollow portion 3a because the upper inner face 3b has a dome-like shape or the like, and thus the liquid is unlikely to fall as droplets. Furthermore, even when part of the liquid condensed on the upper inner face 3b falls as droplets, the electric field intensity on the upper inner face 3b is not high because microwaves are emitted from the waveguide 7 having the portion 7a protruding from the upper inner face 3b, and thus the potential difference between the falling droplets and the upper inner face 3b does not increase, as shown in simulation results below. As a result, it is possible to suppress the occurrence of sparking between the falling droplets and the upper inner face 3b. When the treatment on the content 31 is completed, the microwave generation by the microwave generator 5 is stopped. The valve of the outlet pipe 23 is opened to allow the content 31 to be discharged from the vessel 3. In this way, a series of batch processing is completed.

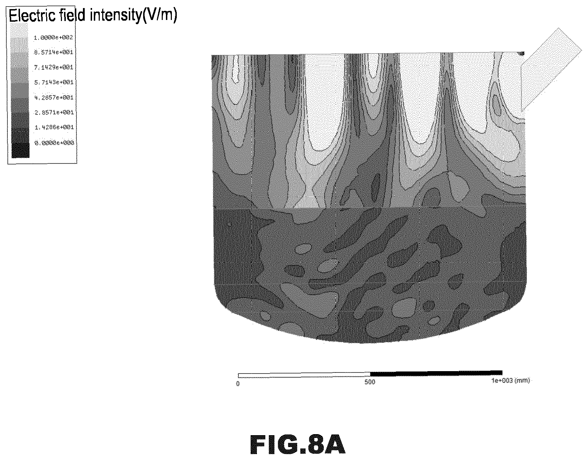

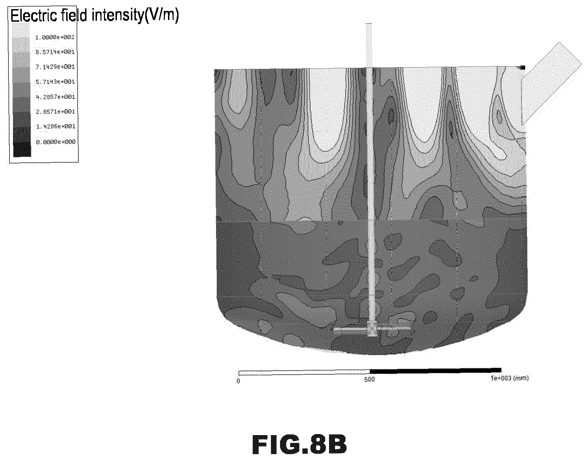

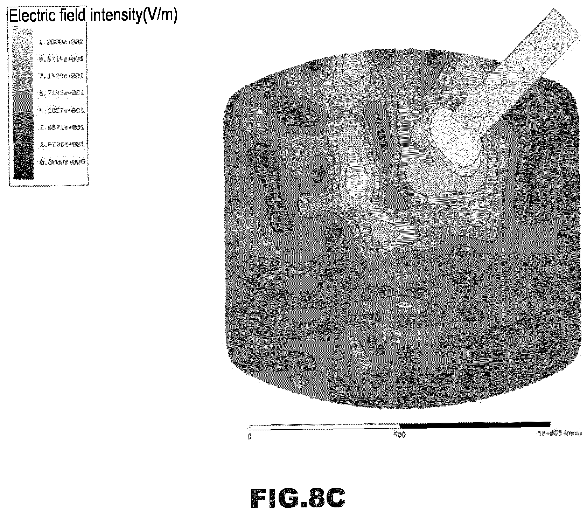

Next, simulation results of comparative examples and examples will be described. In the comparative examples, simulations were performed for a microwave treatment apparatus with a flat upper inner face, a waveguide connected to the side face thereof, and no waveguide protruding into the hollow portion thereof. Comparative Example 1 in FIG. 8A shows simulation results of a microwave treatment apparatus not provided with a stirring unit, and Comparative Example 2 in FIG. 8B shows simulation results of a microwave treatment apparatus provided with a stirring unit. FIGS. 8C to 8F respectively show simulation results of Examples 1 to 4. In Examples 1 and 2, the plane including the opening at the end of the waveguide 7 is perpendicular to the longitudinal direction of the waveguide 7, and, in Examples 3 and 4, the plane including the opening at the end of the waveguide 7 is perpendicular to the central axis of the hollow portion 3a. Examples 1 and 3 show simulation results of the microwave treatment apparatus 1 not provided with a stirring unit, and Examples 2 and 4 show simulation results of the microwave treatment apparatus 1 provided with a stirring unit. In these simulations, the angle between the longitudinal direction of the waveguide and the central axis of the hollow portion was set to 45° such that the straight line including the central axis of the waveguide and the central axis of the hollow portion intersected each other. The content used was organic solvent.

In the simulation results in FIGS. 8A to 8F, whiter areas are areas with higher electric field intensity. It is seen that, in Comparative Examples 1 and 2 (FIGS. 8A and 8B), there are areas with high electric field intensity at multiple points on the upper inner face. In areas with high electric field intensity, the potential difference between points is large even when distance between the points is short. Therefore, in Comparative Examples 1 and 2, when liquid condensed on the upper inner face of the hollow portion falls as droplets, the potential difference between the upper inner face and the droplets is large, and thus sparking is highly likely to occur therebetween.

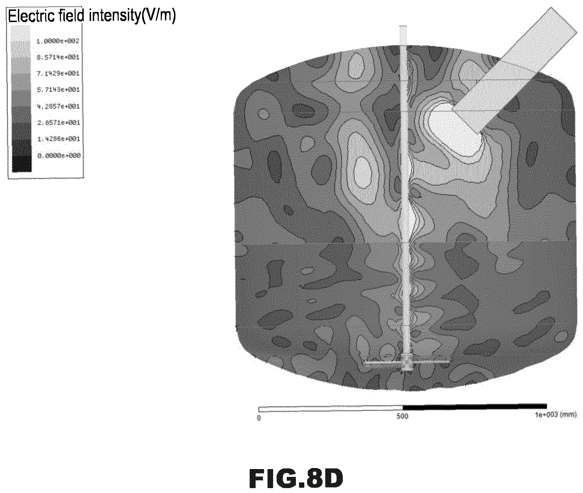

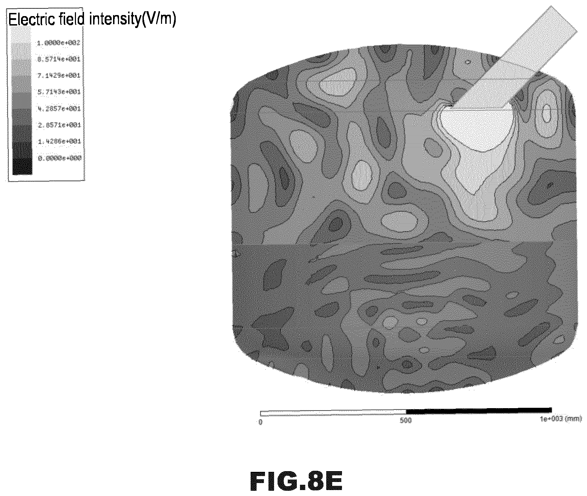

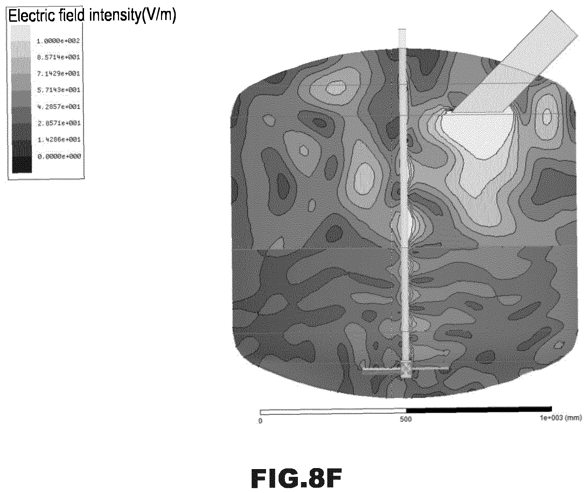

On the other hand, in Examples 1 to 4, the areas with high electric field intensity on the upper inner face 3b are limited. Therefore, even when liquid condensed on the upper inner face 3b falls as droplets, the potential difference between the upper inner face 3b and the droplets is smaller than that in Comparative Examples 1 and 2, and thus sparking is less likely to occur therebetween. In Examples 1 to 4, the upper inner face 3b has a dome-like shape, and thus liquid condensed on the upper inner face 3b flows along the upper inner face 3b toward the hollow portion 3a, and thus the liquid is unlikely to fall as droplets from the upper inner face 3b. In Examples 3 and 4 in FIGS. 8E and 8F, the electric field intensity below the end of the waveguide 7 is high. Therefore, it is seen that the orientation of microwaves emitted from the opening of the waveguide 7 is bent downward by setting the plane including the opening at the end of the waveguide 7 to be perpendicular to the central axis of the hollow portion 3a. Respective comparisons between FIGS. 8A, 8C, and 8E and FIGS. 8B, 8D, and 8F show that there is no significant change in the electric field intensity caused by the presence or absence of the stirring unit.

## Claims

1. A microwave treatment apparatus comprising:
a vessel having a pillar-shaped hollow portion configured to contain a liquid-phase content, and an upper inner face that includes at least partial area whose height decreases along a direction from a central axis of the hollow portion to the periphery when the vessel is located such that a direction along the central axis is along a vertical direction; and
a waveguide having a portion protruding from the upper inner face into the hollow portion, and configured to introduce microwaves into the hollow portion.

2. The microwave treatment apparatus according to claim 1, wherein the waveguide protrudes from the at least partial area of the upper inner face into the hollow portion.

3. The microwave treatment apparatus according to claim 1 or 2, wherein the at least partial area has a dome-like shape.

4. The microwave treatment apparatus according to any one of claims 1 to 3, further comprising a microwave generator that generates microwaves,
wherein microwaves generated by the microwave generator are introduced into the hollow portion via the waveguide.

5. The microwave treatment apparatus according to any one of claims 1 to 4, further comprising:
a stirring shaft that penetrates the upper inner face of the vessel, and is coaxial with the central axis of the hollow portion; and
a stirring blade that is connected to the stirring shaft.

6. The microwave treatment apparatus according to any one of claims 1 to 5, wherein the waveguide is provided such that a central axis of the waveguide is at an angle to the central axis of the hollow portion.

7. The microwave treatment apparatus according to claim 6, wherein a plane including an opening at an end of the waveguide is perpendicular to the central axis of the hollow portion.

8. The microwave treatment apparatus according to any one of claims 1 to 7, wherein a surface of the upper inner face of the hollow portion has good wettability to the content.

9. The microwave treatment apparatus according to any one of claims 1 to 8,
wherein the vessel includes an outer-pipe portion protruding outward from the vessel and having one end that is connected to the hollow portion at the upper inner face, and
the waveguide includes an inner-pipe waveguide located inside the outer-pipe portion such that one end thereof protrudes from the upper inner face into the hollow portion.

10. The microwave treatment apparatus according to any one of claims 1 to 8,
wherein the waveguide penetrates an opening formed through the vessel, and
the waveguide is welded to the vessel at the opening.

11. The microwave treatment apparatus according to any one of claims 1 to 8,
wherein the waveguide includes a waveguide outside the vessel and a waveguide inside the vessel, the waveguides facing each other at an opening formed through the vessel, and
the waveguide inside the vessel is detachably attached to the vessel.

12. A microwave treatment method comprising:
a step of allowing a liquid-phase content to flow into a pillar-shaped hollow portion included in a vessel and configured to contain the content when the vessel is located such that a direction along a central axis of the hollow portion is along a vertical direction; and
a step of irradiating the content with microwaves emitted via a waveguide having a portion protruding from an upper inner face of the vessel into the hollow portion,
wherein the upper inner face includes at least partial area whose height decreases along a direction from the central axis to the periphery.
